# EUROPEAN PATENT APPLICATION

(11) **EP 1 530 085 A2**
(43) Date of publication of application: **11.05.2005**
(21) Application number: 04256899.8
(22) Date of filing: 08.11.2004
(51) Int. Cl.: G03F 1/14, G03F 7/00, G02F 1/1335

(54) **Electro-optic device substrate and method for manufacturing the same, electro-optic device and method for manufacturing the same, photomask, and electronic device**

(30) Priority: 10.11.2003 JP 2003380001; 10.11.2003 JP 2003380000
(71) Applicant: SEIKO EPSON CORPORATION, Tokyo 160-0811 (JP)
(72) Inventor: Nakano, Tomoyuki, Suwa-shi Nagako-ken 392-8502 (JP); Kaneko, Hideki, Suwa-shi Nagako-ken 392-8502 (JP); Otake, Toshihiro, Suwa-shi Nagako-ken 392-8502 (JP); Takizawa, Keiji, Suwa-shi Nagako-ken 392-8502 (JP)
(74) Representative: Kenyon, Sarah Elizabeth

(57) **Abstract**

A photomask is used for an exposure process for roughening the surface of a process region of a film. The photomask includes a first region and a second region. The first region serves as a transmissive portion that transmits light traveling toward the periphery of the process region. The second region includes a plurality of dot regions each having a light-shielding portion for shielding the light traveling toward the process region and a semitransmissive portion that transmits the light traveling toward the process region in a region other than the dot regions, the semitransmissive portion transmitting the light at a lower transmittance than that of the transmissive portion.

## Description

The present invention relates to a technique for scattering reflected light by using a reflecting layer with a roughened surface.

So-called reflective liquid crystal displays have a light-reflective reflecting layer on the surface of a substrate that holds liquid crystal. Extraneous light such as sunlight or interior illumination light incident from an observer side is reflected by the surface of the reflecting layer. The reflected light is used to display an image. If the surface of the reflecting layer is a perfect plane in this structure, the light incident on the liquid crystal display is viewed by the observer while being mirror-reflected by the surface of the reflecting layer. This has the problem that the image of a person or object that faces the display surface of the liquid crystal display is viewed in addition to the original display image, making it difficult to view.

In order to prevent the reflection of the background, the surface of the reflecting layer has a large number of fine projections and recesses (hereinafter, referred to as a scattering structure). The light reflected by the surface of the reflecting layer with such a structure is scattered appropriately toward the observation side, so that the reflection of the background can be prevented. JP-A-2003-75987 (Patent Document 1: Paragraphs 0073 and 0074 and Fig. 12) discloses a method for forming the scattering structure. The method includes a first step of scattering a large number of fine resin pieces onto the surface of the substrate, a second step of forming a film that covers the projections for smoothing the difference in level between the projections and the surface of the substrate, and a third step of forming a reflecting layer such that it covers the film.

The method, however, needs the step of forming a film that covers the projections in addition to the step of forming multiple fine resin pieces onto the substrate, thus posing the problems of complicating the manufacturing process and increasing manufacturing cost. Techniques for solving the problems include a method of forming the reflecting layer so as to cover the resin pieces directly without forming the film. The use of the method, however, can pose the problem of an insufficient light-scattering effect (hereinafter, referred to as a light-scattering effect) because a flat plane that reflects the surface of the substrate which is exposed between the resin pieces and the flat planes at the top of the resin pieces. The present invention has been made in consideration of such problems. Accordingly, it is an object of the invention to provide a reflecting layer having a high light-scattering effect by a simple manufacturing process.

In order to solve the above-described problems, a photomask according to the invention has the following structure. The photomask includes a first region opposed to the periphery (a region other than the process region) of the process region of the film whose surface is to be roughened and a second region opposed to the process region. The second region includes a plurality of dot regions. Those regions (three kinds of regions including the first region, the dot regions, and a region other than the dot regions of the second region) include a transmissive portion that transmits light, a light-shielding portion that shields light, and a semitransmissive portion that transmits light at a lower light transmittance than that of the transmissive portion, respectively. Which of the three portions is disposed to each region is determined appropriately depending on the kind (positive or negative) of a photosensitive material used to form the film to be processed and the shape of the roughened surface to be formed finally.

For example, a photomask used for forming a roughened surface (a roughened surface in which regions of the film which correspond to the dot regions have projections) by removing a region other than the dot regions of the process region of a film made of a positive photosensitive material includes a first region having a transmissive portion that transmits light traveling toward the periphery of the process region and a second region including a plurality of dot regions each having a light-shielding portion that shields light traveling toward the process region and a semitransmissive portion that transmits the light traveling toward the process region in a region other than the dot regions, the semitransmissive portion transmitting the light at a lower transmittance than that of the transmissive portion. A specific example of the structure will be described hereinafter as a first embodiment. A photomask used for forming a roughened surface (a roughened surface in which regions of the film which correspond to the dot regions has recesses) by removing a region other than the dot regions of the process region of a film made of a positive photosensitive material includes a first region having a transmissive portion that transmits light traveling toward the periphery of the process region and a second region including a plurality of dot regions each having a semitransmissive portion that transmits the light traveling toward the process region at a lower transmittance than that of the transmissive portion and a light-shielding portion that shields the light traveling toward the process region in a region other than the dot regions. A specific example of the structure will be described hereinafter as a second embodiment.

Since the first regions of the photomasks serve as transmissive portion, light can be applied across the entire thickness of the region around the process region of the film. The second regions of the photomasks have a light-shielding portion in one of the dot regions and a region other than those and a semitransmissive portion in the other region. With such a structure, of the light that travels from the light source toward the film, the amount of light that passes through the second region is limited. Accordingly, even when a sufficient amount of light to photodecompose the entire thickness of the region of the film around the process region is emitted from the light source, only part of the thickness of the process region of the film can be selectively photodecomposed. Therefore, the process region is not completely removed by developing the film, so that the surface of the substrate having the film is not exposed in the process region. Thus an electrooptic device substrate (reflecting substrate) having the ground layer formed by developing the film exposed with the photomasks has no flat surface which reflects the flat surface of the substrate and as such, exhibits a preferable light-scattering effect. Moreover, with the photomask according to the invention, the portion of the film which is exposed to light across the entire thickness, the portion that is not exposed to light, and the portion in which only part of the thickness is exposed to light can be formed by the common process.

According to another aspect of the invention, the photomask includes a peripheral transmissive portion in contact with the entire edge or part of the edge of each dot region. The peripheral transmissive portion transmits light at substantially the same transmittance as that of the transmissive portion in the first region. With such a structure, of the light that travels from the light source toward the film, the light that has passed through the peripheral transmissive portion is diffracted around the edge of each dot region, and the diffracted light is intensified at the surface of the film. Therefore, in addition to the region of the film which is irradiated with the light that has passed through the semitransmissive portion, the region irradiated with the diffracted light that has passed through the peripheral transmissive portion is also photodecomposed and so, a fine recess is formed in each of the regions of the ground layer formed by developing the film, which correspond to the dot regions. Forming a thin-film reflecting layer on the roughened surface of the ground layer offers a preferable light-scattering effect as compared with a case in which the reflecting layer is formed on a roughened surface of which the tops of the projections or the bottoms of the recesses are flat.

The photomask may be constructed such that the peripheral transmissive portion is in contact with the entire edge of each dot region or, alternatively, the peripheral transmissive portion that transmits light at substantially the same light transmittance as that of the transmissive portion is interposed between the dot region and the semitransmissive portion. Such a structure ensures the amount of light that is diffracted at the edge of the dot region into the film, thus forming a recess with a prescribed depth at the top of the projection of the roughened surface. According to the embodiments, the amount of light that has passed through the peripheral transmissive portion and is diffracted at the edge of the dot region (in other words, the depth of the recess formed at the top of the projection on the roughened surface) is adjusted according to the length of the contact portion with the edge of the dot region in the peripheral transmissive portion. Accordingly, it is preferable to select the structure of the peripheral transmissive portion according to the depth of the recess to be formed on the top of the projection on the roughened surface. Specifically, the invention may adopt a structure in which the peripheral transmissive portion is disposed in contact with the entire edge of the dot region or a structure in which the peripheral transmissive portion is disposed in contact with part of the edge of the dot region. The former structure can increase the amount of diffracted light at the edge of the light-shielding portion as compared with the latter structure, thereby allowing a deep recess to be formed at the top of the projection on the roughened surface. In other words, the latter structure allows the depth of the recess formed on the top of the projection on the roughened surface to be reduced.

On the other hand, a photomask used for forming a roughened surface (a roughened surface in which regions of the film which correspond to the dot regions have projections) by removing a region other than the dot regions of the process region of a film made of a negative photosensitive material includes a first region having a light-shielding portion that shields light traveling toward the periphery of the process region and a second region including a plurality of dot regions each having a transmissive portion that transmits light traveling toward the process region and a semitransmissive portion that transmits the light traveling toward the process region in a region other than the dot regions, the semitransmissive portion transmitting the light at a lower transmittance than that of the transmissive portion. A specific example of the structure will be described hereinafter as a third embodiment. A photomask used for forming a roughened surface (a roughened surface in which regions of the film which correspond to the dot regions have recesses) by removing the dot regions of the process region of a film made of a negative photosensitive material includes a first region having a light-shielding portion that shields light traveling toward the periphery of the process region; and a second region including a plurality of dot regions each having a semitransmissive portion that transmits light traveling toward the process region at a lower transmittance than that of the transmissive portion and a transmissive portion that transmits the light traveling toward the process region in a region other than the dot regions. A specific example of the structure will be described hereinafter as a fourth embodiment. The use of the photomask facilitates forming the ground layer of the reflecting layer having a preferable light-scattering effect, as with the above-described photomask for exposing the positive photosensitive material.

A sufficient amount of light must be emitted from the light source to completely remove the periphery of the process region of the film. When the semitransmissive portion of the photomask used for the exposure process has relatively high transmittance, the amount of light that passes through the semitransmissive portion into the process region increases, thus having the possibility of photodecomposing the entire thickness of the film at that region. If the process region is removed as has been described, the surface of the substrate is exposed to cause a decrease of the light-scattering effect. In order to prevent the problem, it is desirable that the light transmittance of the semitransmissive portion be sufficiently lower than that of the transmissive portion. Test results by the inventor have shown that when the light transmittance of the semitransmissive portion for the light from the light source is set to at least 10 percent and at most 40 percent, a roughened surface capable of achieving a preferable light-scattering effect is formed. Accordingly, the light transmittance of the semitransmissive portion of the photomask according to the invention is preferably set to at least 10 percent and at most 40 percent.

The semitransmissive portion may have any specific structure only if it has lower light transmittance than the transmissive portion. For example, an extremely thin light-shielding film absorbs or reflects part of light that is applied thereto and transmits other part of the light. Such a light-shielding thin film may be used as the semitransmissive portion. Alternatively, a sheet-like arrangement of multiple fine light-shielding portions and multiple fine transmissive portions may be used as the semitransmissive portion. Such a structure also allows part of the light from the light source to be shielded by the fine light-shielding portions and other part to be passed through the fine transmissive portions. Although the fine light-shielding portions and the fine transmissive portions may be disposed in any arrangements, it is preferable to use a semitransmissive portion in which the fine light-shielding portions and the fine transmissive portions are arranged alternately in a first direction and a second direction (in checkered pattern), in viewpoint of uniformizing the amount of light that passes through the semitransmissive portion into the film in the plane of the semitransmissive portion. With such a structure, in order to prevent the mutual interference of the light that has passed through the fine transmissive portions and is diffracted at the edge of the fine light-shielding portions, it is preferable to set the side of each of the fine light-shielding portions and the fine transmissive portions at 2 µm or less and, more preferably, at 1.5 µm or less. Another aspect of the invention, the semitransmissive portion may have a structure in which the fine light-shielding portions and the fine transmissive portions extending in a first direction are disposed alternately in a second direction orthogonal to the first direction (stripe pattern). Also with such a structure, in order to prevent the mutual interference of the light that has passed through the fine transmissive portions and is diffracted at the edge of the fine light-shielding portions, it is preferable to set the width of each of the fine light-shielding portions and the fine transmissive portions at 2 µm or less and, more preferably, at 1.5 µm or less.

According to another aspect of the invention, each dot region of the photomask is polygonal in planar shape. When the area of the dot region is too large, the top of the projection or the bottom of the recess of the roughened surface of the film becomes flat to decrease the light-scattering effect by the reflecting layer formed on the roughened surface. On the other hand, when the area of the dot region is too small, the light from the light source which is diffracted at the boundary of the dot regions and a region other than those interferes with each other, so that a prescribed surface film surface cannot be formed. Test results by the inventor have shown that it is therefore desirable to set the diameter of the circumscribed circle of the polygon to at least 8.0 µm and at most 11.0 µm. Consequently, it is desirable to set the diameter of the circumscribed circle of the polygon of the dot region to at least 8.0 µm and at most 11.0 µm and, more desirably, at least 9.0 µm and at most 10.0 µm.

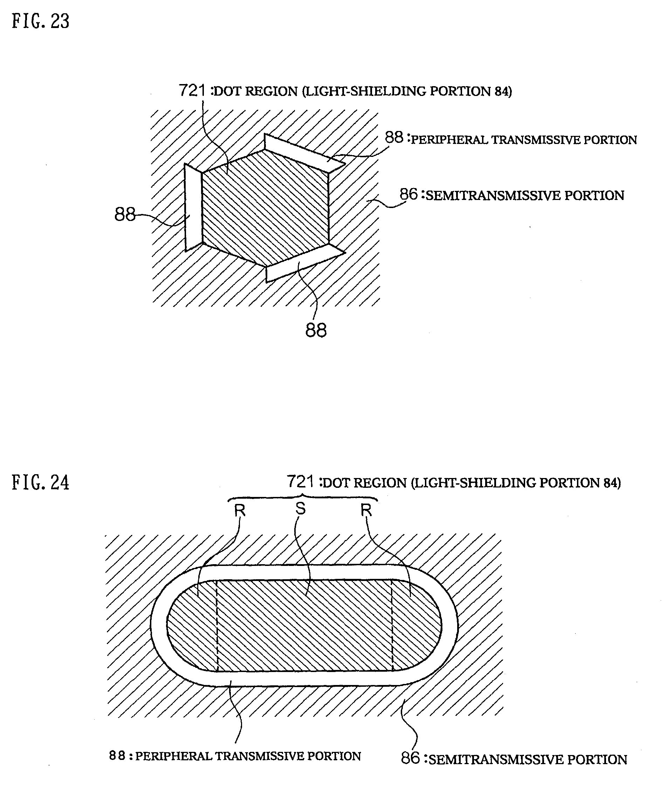

Preferably, the photomask according to the invention has a dot region (light-shielding portion) shaped like a substantially oblate figure in planar shape or a substantially polygon in planar shape whose circumscribed circle is oblate. The "oblate figure" in the invention is an ellipse other than a perfect circle and includes various shapes including a shape having a rectangle or square to the opposite sides of which a semicircle with the diameter thereof is added (refer to Fig. 24), in addition to an ellipse. When a photomask in which the planar shape of each dot region is a perfect circle or a polygon whose circumscribed circle is a perfect circle is used for exposure (hereinafter, referred to as a comparative example), diffracted light around the entire edge of the dot region is concentrated in a small region of the film (in the center of the film which overlaps with the dot region) at substantially the same phase, thus intensifying each other. In that case, intense light is applied to the portion in which the diffracted light is concentrated, or the region of the film which is to be the top of the projection of the roughened surface, so that a roughened surface formed by the following development will have a deep recess at the top of the projection. If the top of the projection is a flat surface having no recess, mirror reflection will occur at the surface of the reflecting layer which covers the top of the projection, having limits in offering a preferable light-scattering effect. Accordingly, in order to offer a preferable light-scattering effect, it is preferable to provide a recess at the top of the projection on the roughened surface. However, test results by the inventor have shown that the use of the photomask according to the comparative example excessively increases the recess of the top of the projection, reducing the light-scattering effect

In view of the findings, when the planar shape of each dot region is a substantially oblate figure or substantially a polygon whose circumscribed circle is an oblate figure, diffracted light around the edge of the dot region is scattered into the film, in a wider region than the area of the region in which the diffracted light is concentrated when the photomask according to the comparative example is used. Consequently, the intensity of light applied to the portion of the film which is to be the top of the projection of the roughened surface is weakened as compared with the comparative photomask, preventing the recess at the top of the projection from becoming too deep by the following development.

Preferably, the photomask according to the invention has the dot regions arranged longitudinally in the same direction. The light that has reached the surface of the reflecting layer formed on the roughened surface of the film is mainly scattered by the slopes (sides) of the projections formed on the surface of the reflecting layer. Accordingly, when the light-shielding regions are arranged longitudinally in the same direction, light display can be achieved across the wide viewing angle along one of the lateral length and the vertical length of the display surface. A specific example of the structure will be described hereinafter as a fifth embodiment.

When the dot regions are disposed too densely or too non-densely, the flatness of the roughened surface formed by the development after exposure process increases, causing a decrease in the light-scattering effect of the reflecting layer on the roughened surface. Test results by the inventor have shown that it is desirable that the ratio of the area of the dot regions to the total area of the first region and the second region be at least 30 percent and at most 60 percent.

The invention can be specified as a method for manufacturing an electrooptic device substrate using the photomask described above. More specifically, the method for manufacturing an electrooptic device substrate according to a first aspect of the invention includes a film forming process of forming a film of a positive photosensitive material; an exposure process of exposing the film to light through a photomask, the process including the step of shielding light from a light source traveling toward one of regions to be the projections of the roughened surface and regions to be the recesses with a light-shielding portion of the photomask and the step of passing light from the light source traveling toward the other of the regions through a semitransmissive portion of the photomask, thereby applying the light only to part of the thickness of the film; a developing process of developing the exposed film to form the ground layer; and a reflecting-layer forming process of forming the reflecting layer having light reflexibility on the roughened surface of the ground layer formed by the developing process. A method for manufacturing an electrooptic device substrate according to a second aspect of the invention includes a film forming process of forming a film of a negative photosensitive material; an exposure process of exposing the film to light through a photomask, the process including the step of passing light from a light source traveling toward one of regions to be the projections of the roughened surface and regions to be the recesses through a transmissive portion of the photomask, thereby applying the light to the entire thickness of the film and the step of passing light from the light source traveling toward the other of the regions through a semitransmissive portion of the photomask, thereby applying the light only to part of the thickness of the film; a developing process of developing the exposed film to form the ground layer; and a reflecting-layer forming process of forming the reflecting layer having light reflexibility on the roughened surface of the ground layer formed by the developing process. The manufacturing methods facilitate manufacturing an electrooptic device substrate having a preferable light-scattering effect by the same reason as has been described for the photomasks according to the invention.

An electrooptic device is manufactured by disposing an electro-optic material so as to face the reflecting layer of the electrooptic device substrate manufactured by the foregoing manufacturing methods. The manufacturing method facilitates an electrooptic device having preferable display definition by reducing the reflection of background. The electro-optic material in the invention denotes a substance that converts an electric action such as application of voltage or supply of current to a change in optical characteristic such as a change in brightness or light transmittance. Although a typical example of the electro-optic material is liquid crystal, the scope of the application of the invention is not limited to that.

The electrooptic device substrate according to the invention includes a ground layer having a plurality of projections on the surface, the projections each having a recess on the top thereof and a light-reflective reflecting layer disposed on the surface of the plurality of projections of the ground layer. When the surface of the projection of the ground layer is a smooth surface as described in Patent Document 1, the surface of the reflecting layer formed on the surface thereof also has a similar smooth surface. Since the smooth surface causes mirror reflection of light, it cannot always offer a preferable light-scattering effect even with a roughened surface of the reflecting layer. In contrast, the ground layer of the electrooptic device substrate according to the invention has multiple projections each having a recess on the top thereof, thus having less flatness on the surface of the reflecting layer than that of the reflecting layer described in Patent Document 1. Accordingly, the electrooptic device substrate according to the invention offers a preferable light-scattering effect. The ground layer of the electrooptic device substrate according to the invention can be formed by developing the film after exposure using the photomask which has a peripheral transmissive portion around each dot region.

The electrooptic device substrate according to the invention includes a ground layer having a plurality of projections on the surface, the projections being substantially oblate in planar shape and each having a recess on the top thereof; and a light-reflective reflecting layer disposed on the surface of the ground layer having the plurality of projections. Since the electrooptic device substrate has a recess at the top of each projection on the roughened surface of the ground layer, the ratio of the flat portion on the surface of the reflecting layer is small, thus offering a preferable light-scattering effect. The ground layer of the electrooptic device substrate can be formed by developing the film after exposure using the photomask according to the invention.

The electrooptic device substrate according to the invention is used as the substrate of an electrooptic device. The electrooptic device includes a first substrate and a second substrate opposed to each other and having an electro-optic material therebetween, a ground layer disposed on the surface of the second substrate facing the electro-optic material and having a plurality of projections on the surface, the projections each having a recess on the top thereof, and a light-reflective reflecting layer disposed on the surface of the ground layer having the plurality of projections. The use of the electrooptic device allows incident light from the first substrate to be reflected toward the first substrate by the reflecting layer in a preferable scattered manner, providing a preferable display definition by reducing the reflection of background. The invention is also specified as an electronic device incorporating the electrooptic device as a display device. Electrooptic devices of this type include cellular phones, personal computers, etc.

Embodiments of the present invention will now be described by way of further example only and with reference to the accompanying drawings, in which:
Fig. 1 is a cross-sectional view showing the structure of a liquid crystal display according to a first embodiment of the present invention;
Fig. 2 is an enlarged perspective view showing the structure of a main part of the liquid crystal display;
Fig. 3 is a perspective view of the surface structure of the ground layer of the liquid crystal display;
Fig. 4 is an enlarged cross-sectional view of projections of the ground layer;
Fig. 5 is a cross-sectional view showing the process of manufacturing the elements on a second substrate of the liquid crystal display;
Fig. 6 is a cross-sectional view of photodecomposed part of the film by an exposure process;
Fig. 7 is a plan view showing the structure of a photomask;
Fig. 8 is a cross-sectional view of the photomask;
Fig. 9 is a plan view showing the concrete structure of a semitransmissive portion adopting gray tone;
Fig. 10 is a plan view of the specific structure of the semitransmissive portion adopting the gray tone;
Fig. 11 is an enlarged plan view of a dot region of the photomask;
Fig. 12 is a cross-sectional view showing the path of light emitted from a light source to the vicinity of the dot region;
Fig. 13 is a plan view showing the structure of a photomask according to a second embodiment of the invention;
Fig. 14 is a plan view showing the structure of a photomask according to a third embodiment of the invention;
Fig. 15 is a plan view showing the structure of a photomask according to a fourth embodiment of the invention;
Figs. 16A to 16C are enlarged views of the projection of the ground layer and the reflecting layer of a liquid crystal display according to a fifth embodiment of the invention;
Fig. 17 is a plan view of an arrangement of multiple projections on the surface of the ground layer;
Fig. 18 is a plan view of another arrangement of multiple projections on the surface of the ground layer;
Fig. 19 is a plan view showing the structure of a photomask according to the fifth embodiment of the invention;
Fig. 20 is an enlarged plan view of the dot region of the photomask according to the fifth embodiment;
Fig. 21 is a cross-sectional view showing the path of light emitted from a light source to the vicinity of the dot region;
Fig. 22 is a cross-sectional view of a liquid crystal display according to a modification of the invention;
Fig. 23 is an enlarged plan view of a dot region of the photomask according to another modification;
Fig. 24 is a plan view of the shape of a dot region according to another modification;
Fig. 25 is an enlarged plan view of a dot region according to another modification;
Fig. 26 is a perspective view of a cellular phone which is an example of an electronic device according to the invention; and
Fig. 27 is a perspective view of a digital still camera which is an example of an electronic device according to the invention.

Although the embodiments represent examples in which the invention is applied to a liquid crystal display which uses liquid crystal as an electro-optic material, it is to be understood that the scope of the invention is not limited to that. In the drawings, the size and ratio of the components are different from those of actual ones for the convenience of description.

### <A: First Embodiment>

### <A-1: Structure of Liquid Crystal Display>

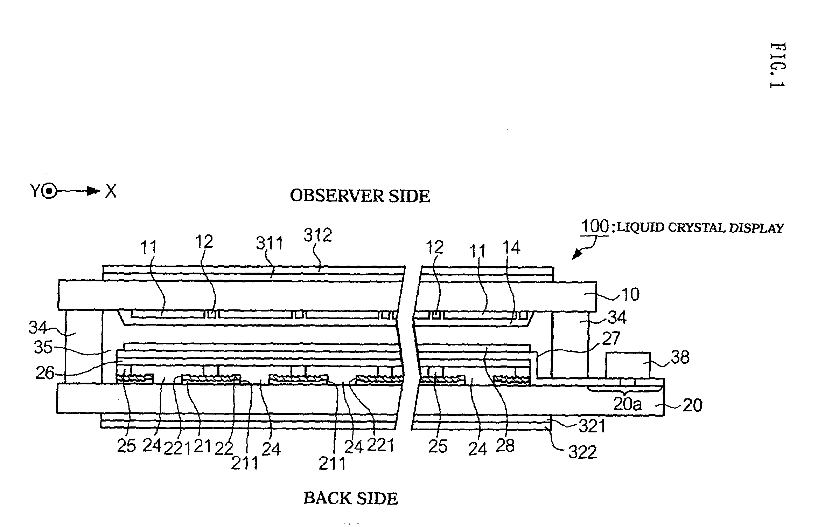

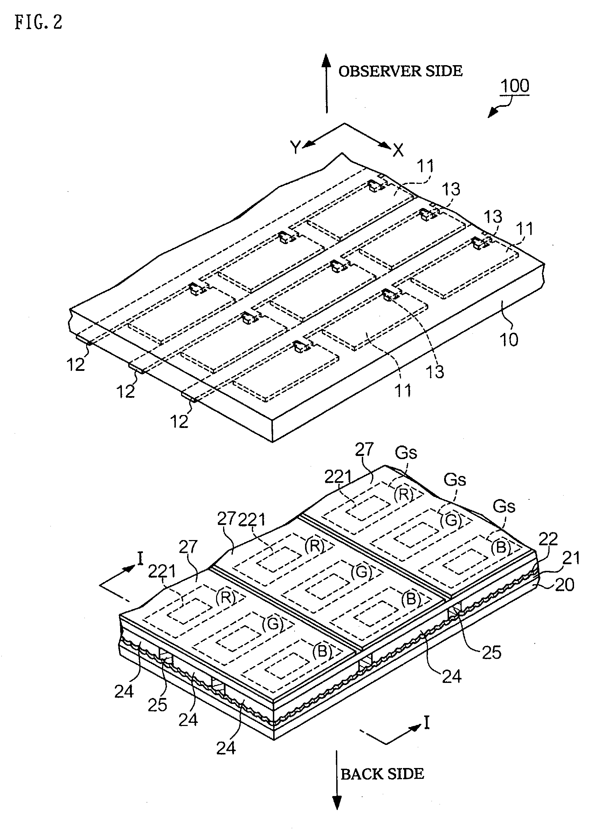

Fig. 1 is a cross-sectional view showing the structure of a liquid crystal display according to a first embodiment of the present invention. Fig. 2 is an enlarged perspective view of the structure of a main part of the liquid crystal display. The cross section taken on line I-I of Fig. 2 corresponds to Fig. 1. As shown in the drawings, a liquid crystal display 100 includes a first substrate 10 and a second substrate 20 which are disposed so as to face each other with a substantially rectangular-frame-shaped sealing member 34 interposed therebetween. The substrates 10 and 20 are plate-like or film-like members made of an optically transmissive material such as glass or plastic. The space surrounded by the substrates 10 and 20 and the sealing member 34 contains sealed twisted nematic (TN type) liquid crystal 35, for example. The side adjacent to the first substrate 10 as viewed from the liquid crystal 35 is expressed as "observer side," as shown in Figs. 1 and 2. In other words, this is the side on which an observer who views a display image by the liquid crystal display 100 is located. In contrast, the side of the second substrate 20 as viewed from the liquid crystal 35 is expressed as "back side." The observer-side surface of the first substrate 10 has a retardation film 311 for improving the contrast of the display image and a polarizing plate 312 for polarizing incident light. The back-side surface of the second substrate 20 has a similar retardation film 321 and a polarizing plate 322 (not shown in Fig. 2). The second substrate 20 includes a part (hereinafter, referred to as an extending part) 20a extending from the periphery of the first substrate 10. The extending part 20a has an IC chip 38 having a circuit for driving the liquid crystal display 100 by a chip-on-glass (COG) technique.

The surface of the first substrate 10 which faces the liquid crystal 35 has a plurality of pixel electrodes 11 in matrix form. Each pixel electrode 11 is a substantially rectangular electrode made of an optically transparent conductive material such as indium tin oxide (ITO). Scanning lines 12 extend in the Y-direction between the pixel electrodes 11 which are adjacent in the X-direction. Each pixel electrode 11 connects to the scanning line 12 via a thin film diode (TFD) element 13. The TFD element 13 is a two-terminal switching element having a nonlinear current-voltage characteristic. The surface of the first substrate 10 which has those elements is covered with an alignment film 14 subjected to rubbing process (not shown in Fig. 2).

The surface of the second substrate 20 which faces the liquid crystal 35 has a plurality of data lines 27 extending in the X-direction. Each data line 27 is an electrode made of an optically transparent conductive material such as ITO, as with the pixel electrode 11. The data lines 27 face the pixel electrodes 11 which are arranged in a row in the X-direction on the first substrate 10. The surface of the second substrate 20 which has those data lines 27 is covered with an alignment film 28 similar to the alignment film 14. With such a structure, the liquid crystal 35 sandwiched between the first substrate 10 and the second substrate 20 changes in orientation depending on the voltage applied between the pixel electrodes 11 and the opposing data lines 27 from the IC chip 38. As shown in Fig. 2, each of regions where the orientation changes (hereinafter, referred to as a subpixel) Gs is assigned any of red, green, and blue.

The surface of the second substrate 20 which faces the liquid crystal 35 has a ground layer 21, a reflecting layer 22, a color filter 24, and an insulating layer 26 deposited in that order from the second substrate 20. The data lines 27 and the alignment film 28 are formed on the surface of the insulating layer 26. The color filter 24 is a resin layer corresponding to each subpixel Gs. The color filters 24 are each colored in the color of the subpixel Gs with pigment or dye. The subpixels Gs corresponding to the red, green, and blue color filters 24 form pixels which are the minimum units of a display image. A light-shielding layer 25 is disposed in the space among the color filters 24 (the space among the adjacent subpixels Gs). The light-shielding layer 25 is made of a resin material in which carbon black is dispersed or a light-shielding metallic material such as chrome and serves to shield light among the subpixels Gs. The insulating layer 26 covers the color filter 24 and the light-shielding layer 25 with various kinds of resin materials such as epoxy and acrylic resins. The insulating layer 26 acts to smooth the difference in level between the color filter 24 and the light-shielding layer 25 and prevent the pigment or dye of the color filter 24 from oozing into the liquid crystal 35.

The ground layer 21 is a film provided on the surface of the second substrate 20 and is made of a photosensitive resin material such as acrylic or epoxy resin. The ground layer 21 is disposed selectively only in the region of the surface of the second substrate 20 which is surrounded by the sealing member 34 and is not present in the extending part 20a including the IC chip 38. The structure in which the ground layer 21 is formed across the entire surface of the second substrate 20 including the extending part 20a (the structure in which the IC chip 38 is mounted on the surface of the ground layer 21) has the problem that the ground layer 21 tends to peel off from the second substrate 20 together with the IC chip 38 when the IC chip 38 is subjected to an external force. In contrast, the structure in which the ground layer 21 is completely eliminated on the extending part 20a (the structure in which the IC chip 38 is mounted on the second substrate 20 without intermediation of the ground layer 21) has the advantage of being able to work around the problem.

As shown in Figs. 1 and 2, the part of the ground layer 21 which corresponds to the center of each subpixel Gs has an opening 211 which passes through the ground layer 21 across the thickness. The reflecting layer 22 is a thin film made of a light-reflective material such as simple metal such as aluminum or silver or alloy containing the metals as main component and is made on the surface of the ground layer 21. The reflecting layer 22 includes a transmissive portion 221 which is open so as to correspond to the opening 211 of the ground layer 21. The part of the color filters 24 deposited on the ground layer 21 and the reflecting layer 22 reaches the surface of the second substrate 20 via the transmissive portion 221 of the reflecting layer 22 and the opening 211 of the ground layer 21. The light emitted from a backlight unit into the second substrate 20 from the back of the liquid crystal display 100 under the above structure passes through the opening 211 of the ground layer 21 and the transmissive portion 221 of the reflecting layer 22, then passes through the color filters 24 and the liquid crystal 35, and further passes through the first substrate 10 to exit toward the observer side. The light transmitted from the back of the liquid crystal display 100 toward the observer side realizes transmissive-mode display. The extraneous light such as interior illumination light or sunlight which has entered from the observer side of the liquid crystal display 100 into the first substrate 10 reaches the surface of the reflecting layer 22 through the liquid crystal 35 and the color filters 24, where the light is reflected to emerge from the first substrate 10 to the observer side. The light reflected by the reflecting layer 22 toward the observer side realizes reflecting-mode display.

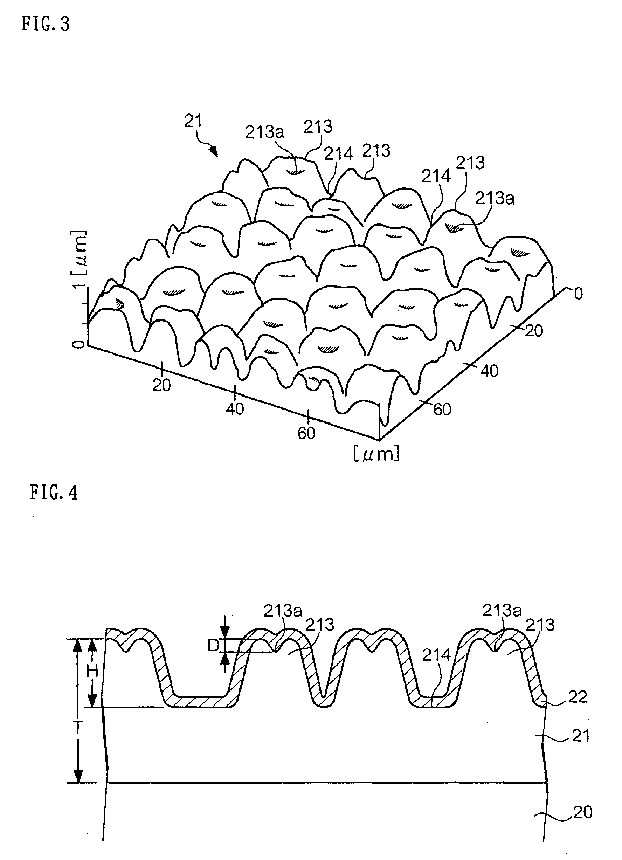

If the surface of the reflecting layer 22 is completely flat, the light incident from the observer side onto the liquid crystal display 100 is mirror-reflected by the surface of the reflecting layer 22. This can pose the problem that the image of the background opposed to the display surface of the liquid crystal display 100 is reflected in the display image. In order to solve the problem, the surface of the reflecting layer 22 according to the embodiment has a scattering structure for scattering the reflected light appropriately. More specifically, the ground layer 21 has a roughened surface including a large number of fine projections or recesses and as such, the surface of the thin-film reflecting layer 22 formed on the surface of the roughened surface also has fine roughness (scattering structure) that reflects the roughened surface of the ground layer 21. Fig. 3 is an enlarged perspective view of the surface structure of the ground layer 21 according to the embodiment. As shown in the drawing, the ground layer 21 has a roughened surface including multiple fine projections 213. The surface of the ground layer 21 can also be grasped as a roughened surface including multiple fine recesses 214, with the plane including the tops of the projections 213 as the reference. Fig. 4 is an enlarged cross-sectional view of the projections 213 of the ground layer 21. As shown in the drawing, let the distance from the top of each projection 213 to the bottom of each recess 214 be the height H of the projection 213 (or the depth of the recess 214). The height H of the projection 213 is smaller than the thickness T of the ground layer 21 (the distance between the contact surface with the second substrate 20 and the top of the projection 213). In other words, the depth of the recess 214 on the surface of the ground layer 21 is smaller than the thickness T of the ground layer 21 and as such, the recess 214 does not therefore pass through the ground layer 21. The depth of the recess 214 on the surface of the ground layer 21 is selected so that the second substrate 20 is not exposed at the bottom of the recess 214.

As shown in Figs. 3 and 4, a recess 213a is provided in the vicinity of the top of each projection 213. The depth D of the recess 213a is smaller than the height H of the projection 213 (or the depth of the recess 214). Since the surface of the ground layer 21 according to the embodiment is roughened as described above, also the surface of the reflecting layer 22 formed on the ground layer 21 has also multiple fine projections each having a recess on the top, as shown in Fig. 4. If the top of each projection which constructs the scattering structure of the reflecting layer 22 is flat, the incident light from the observer side is mirror-reflected by the flat surface, so that sufficient light-scattering effect to prevent the reflection of background cannot always be offered. In contrast, the scattering structure according to the embodiment, shown in Figs. 3 and 4, allows reflected light by the reflecting layer 22 to be scattered also at the tops of the projections 213, providing a preferable light-scattering effect of preventing the reflection of background completely.

### <A-2: Method for Manufacturing Liquid Crystal Display 100)

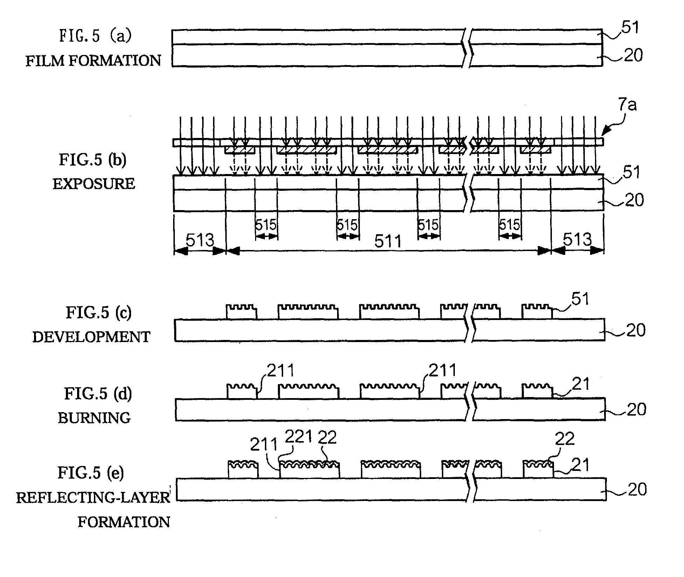

A method for manufacturing the liquid crystal display 100 according to the embodiment will be described with reference to the process of forming the ground layer 21 and the reflecting layer 22 on the second substrate 20. Fig. 5 is a process chart (corresponding to the cross section of Fig. 1) showing the structure of elements on the second substrate 20 during each manufacturing step.

As shown in Fig. 5(a), a film 51 serving as the ground layer 21 is formed on the surface of the second substrate 20. The film 51 is formed by applying a photosensitive positive-type resin material onto the second substrate 20 by a spin coating method. The film 51 is then dried under a reduced pressure and then heated (prebaked) at a temperature from 85°C to 105°C.

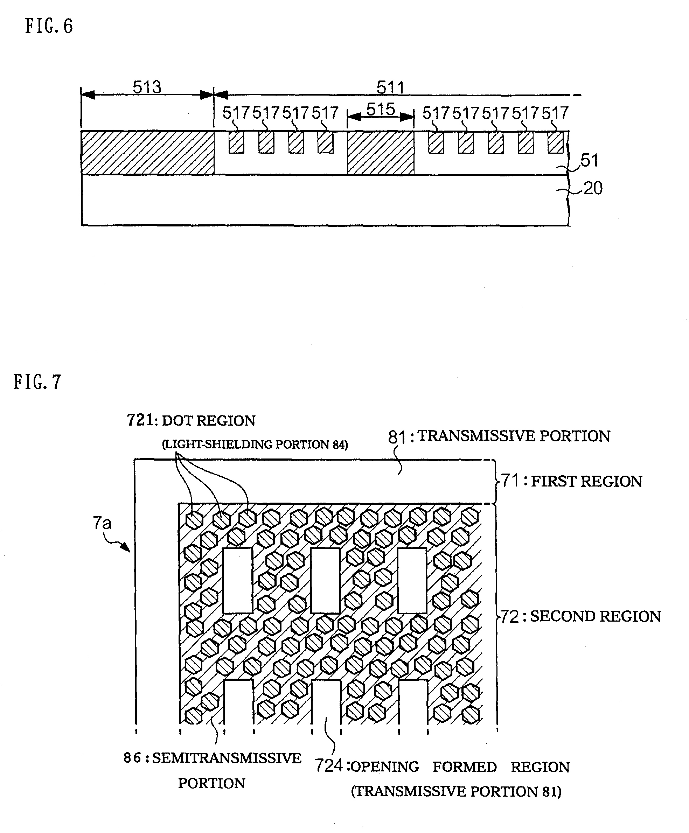

Thereafter, as shown in Fig. 5(b), the film 51 is exposed to light via a mask (hereinafter, referred to as a photomask) 7a. More specifically, the photomask 7a is disposed at a distance about 60 µm apart (a proximity gap) from the surface of the film 51, and light (e.g., i-line) emitted from a light source is applied to the film 51. As shown in Fig. 5(b), in this embodiment, a region (located outside the sealing member 34, hereinafter, referred to as a peripheral region) 513 around a region of the film 51 which is to be left as the ground layer (hereinafter, referred to as a process region) 511, regions 515 corresponding to the openings 211 of the ground layer 21, and regions 517 of the process region 511 which are to be the recesses 214 on the surface of the ground layer 21 are exposed to light collectively. Fig. 6 is a cross-sectional view of the part of the film photodecomposed by the exposure process, showing the vicinity of the boundary between the process region 511 and the peripheral region 513 on enlarged scale. The hatched regions correspond to the part photodecomposed by the exposure. As shown in Figs. 5 and 6, in this embodiment, the peripheral region 513 and the regions 515 corresponding to the openings 211 of the film 51 are photodecomposed across the entire thickness, whereas the regions 517 of the ground layer 21 which are to be the recesses 214 are photodecomposed only in part of the thickness of the film 51. The specific structure of the photomask 7a used in the exposure process will be described later in detail.

The film 51 is then developed. As shown in Fig. 5(c), the part of the film 51 which is photodecomposed by exposure is removed selectively. Subsequently, the film 51 is heated (prebaked) at a temperature from 120°C to 130°C. Only the surface of the film 51 is partly welded by the process, so that the corners of the uneven portions appeared on the surface of the film 51 by development are rounded. Thereafter, the film 51 is burned (postbaked) at a temperature of about 220°C. As shown in Fig. 5(d), the entire surface of the film 51 is shaped by the process steps to form the ground layer 21. The reason why the film 51 is heated in the two steps after development is that if the developed film 51 is immediately heated to about 220°C, the uneven portions of the surface are welded excessively to form a flat surface, resulting in loss in light-scattering effect. Briefly, the process of heating the film 51 at 120°C to 130°C before postbaking can be regarded as the process for maintaining and stabilizing the surface of the film 51 in a prescribed shape.

As shown in Fig. 5(e), the reflecting layer 22 having the transmissive portions 221 is then formed on the surface of the ground layer 21. Specifically, a light-reflective thin film is formed on the surface of the ground layer 21 by film growing such as sputtering, and the thin film is patterned by photolithography and etching to form the reflecting layer 22. As described above, the surface of the reflecting layer 22 is constructed to scatter light, reflected by the roughened surface of the ground layer 21.

Subsequently, the color filters 24 and the light-shielding layers 25 are formed, and then the insulating layer 26 is formed such that it covers them. After the data lines 27 are formed on the surface of the insulating layer 26, the alignment film 28 is formed of an organic thin film such as polyimide and is subjected to rubbing. The elements on the first substrate 10 can be manufactured by various known techniques. The first substrate 10 and the second substrate 20 subjected to the above process steps are bonded together via the sealing member 34, with the respective alignment films 14 and 28 faced each other. The liquid crystal 35 is sealed in the space surrounded by the substrates 10 and 20 and the sealing member 34. The space is then sealed with a sealing material ((not shown)). Thereafter, the retardation film 311 and the polarizing plate 312 are bonded to the first substrate 10, the retardation film 321 and the polarizing plate 322 are bonded to the second substrate 20, respectively, and the IC chip 38 is mounted to the extending part 20a of the second substrate 20 to construct the liquid crystal display 100 shown in Fig. 1.

### <A-3: Structure of Photomask 7a>

The structure of the photomask 7a used in the exposure process (hereinafter, simply referred to as an exposure process) of Fig. 5(b) will be described. Fig. 7 is a plan view showing the structure of the photomask 7a. As shown in the drawing, the photomask 7a according to the embodiment is segmented into a first region 71 and a second region 72 in plan view. The first region 71 is opposed to the peripheral region 513 (s region removed by development as a region that does not construct the ground layer 21) during the exposure process. The second region 72 is opposed to the process region 511 of the film 51 during the exposure process. The second region 72 includes a large number of dot regions 721 which are dispersed at random and regions 724 corresponding to the openings 211 of the ground layer 21 (hereinafter, referred to as opening formed regions). The dot regions 721 of this embodiment correspond to the projections 213 on the surface of the ground layer 21.

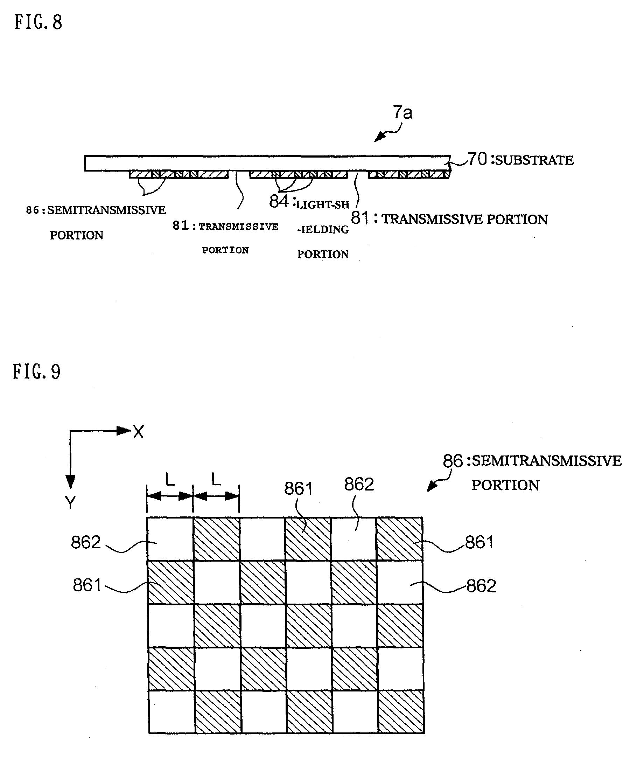

Fig. 8 is a cross-sectional view of the photomask 7a. As shown in the cross section, the photomask 7a includes a substrate 70 and a light-shielding portion 84 and a semitransmissive portion 86 which are formed on the surface of the substrate 70. The substrate 70 is a plate-like member that allows substantially all illumination light from a light source to pass through. Briefly, the light transmittance of the substrate 70 itself to the light emitted from the light source during the exposure process is approximately 100 percent. In contrast, the light-shielding portion 84 is a film that shields (absorbs or reflects) substantially all the illumination light from the light source and is formed of a light-shielding material such as chromium. The semitransmissive portion 86 transmits the illumination light from the light source at a light transmittance lower than that of the substrate 70. In other words, the semitransmissive portion 86 transmits only part of the light emitted from the light source and shields (absorbs or reflects) the other part. Specifically, the semitransmissive portion 86 can employ half tone or gray tone. The semitransmissive portion of the invention is not limited to the following structure.

The half tone is made of a light-shielding material such as chromium oxide (Cr₂O₃) or molybdenum silicide (MoSi or MoSi₂). Such materials are formed in a thin film on the substrate 70 to allow only part of the illumination light from the light source to pass through to reach the film 51 and the other part to be shielded.

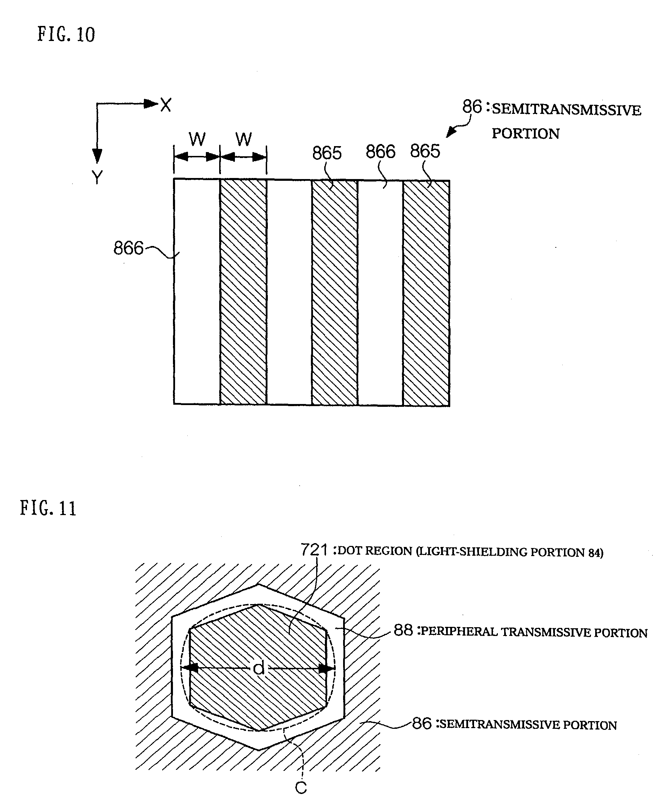

The gray tone includes a large number of fine light-shielding portions and a large number of fine transmissive portions disposed in sheet shape on the substrate 70. The fine light-shielding portions are formed by the process in common with the light-shielding portion 84 and shield substantially all the light from the light source. On the other hand, the fine transmissive portions are portions where the substrate 70 is exposed (in other words, portions having no light-shielding member), thus allowing substantially all the illumination light from the light source to pass through. Since these portions are mixed in a sheet form, part of the light from the light source passes through the fine transmissive portions to reach the film 51, while the other part is shielded by the fine light-shielding portions. It is preferable for the semitransmissive portion 86 which adopts the gray tone that the fine light-shielding portions and the fine transmissive portions be dispersed in the plane of the semitransmissive portion 86 so that the intensity of the transmitted light become substantially uniform across the plane of the semitransmissive portion 86. Figs. 9 and 10 are plan views of preferable arrangements of the fine light-shielding portions and the fine transmissive portions.

Fig. 9 shows an example of a structure in which substantially square fine light-shielding portions 861 and substantially square fine transmissive portions 862 are arranged alternately along the X-direction and the Y-direction orthogonal to each other (so that the fine light-shielding portions 861 and the fine transmissive portions 862 are not adjacent to each other). The light that has passed through the fine transmissive portions 862 is diffracted at the periphery of the fine light-shielding portions 861 to interfere with each other depending on the lengths of the sides of the fine light-shielding portions 861 and the fine transmissive portions 862 and, as a result, a prescribed amount of light can be prevented from being applied to the process region 511. In order to solve the problem, it is preferable to set the length L of each fine light-shielding portions 861 and each fine transmissive portions 862 to at least 1.0 µm and at most 2.0 µm and, more preferably, at most 1.5 µm.

Fig. 10 shows an example of a structure in which linear fine light-shielding portions 865 extending in the Y-direction and linear fine transmissive portions 866 also extending in the Y-direction are arranged alternately in the X-direction orthogonal to the Y-direction (so that the fine light-shielding portions 865 and the fine transmissive portions 866 are not adjacent to each other, respectively). Also in this embodiment, it is preferable to set the width W of each fine light-shielding portion 865 and each fine semitransmissive portion 866 to at least 1.0 µm and at most 2.0 µm and, more preferably, at most 1.5 µm.

The semitransmissive portion 86 of the two semitransmissive portions 86 which uses half tone has the advantage of not occurring diffraction of light that has passed through the semitransmissive portion 86 in principle, as compared with the gray-tone semitransmissive portion 86. The half-tone semitransmissive portion 86 is, however, manufactured by a process different from that for the light-shielding portion 84 of the photomask 7a. In contrast, the gray-tone semitransmissive portion 86 has the advantage of being manufactured by the process common to that for the light-shielding portion 84 of the photomask 7a.

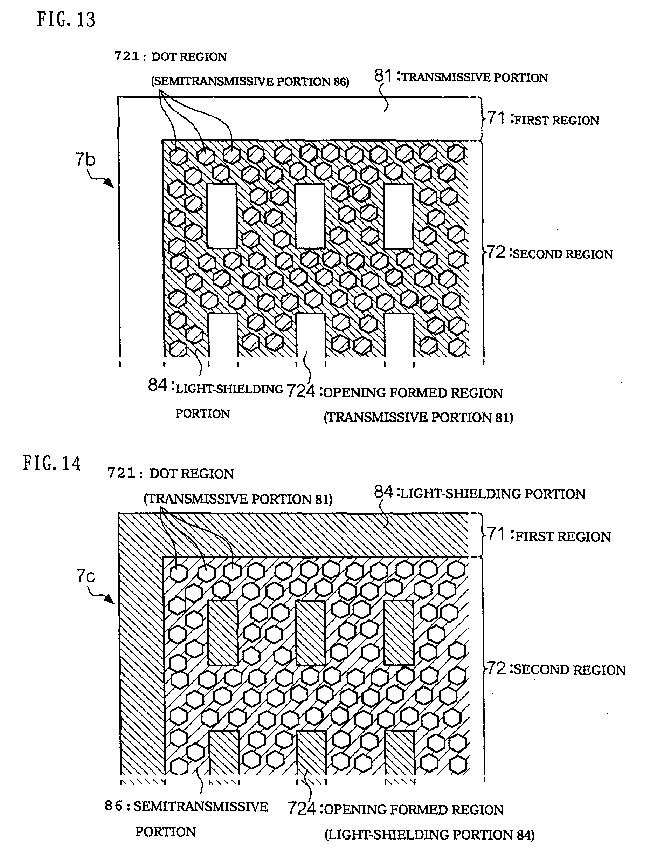

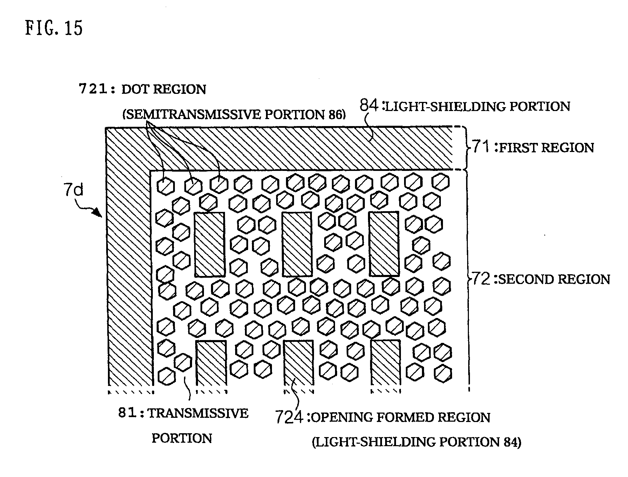

Referring again to Fig. 7, the densely hatched region indicates that the light-shielding portion 84 is provided, the non-densely hatched region shows that the semitransmissive portion 86 is provided, and the no-hatched region indicates that neither of the light-shielding portion 84 and the semitransmissive portion 86 is provided (the same applies to Figs. 13 and 15).

As shown in Fig. 7, the first region 71 of the photomask 7a according to the embodiment has neither of the light-shielding portion 84 and the semitransmissive portion 86. In other words, the first region 71 has only the substrate 70 and thus serves as a transmissive portion 81 that transmits light traveling from the light source to the peripheral region 513. Also the opening formed region 724 has only the substrate 70 as with the first region 71 and as such, serves as the transmissive portion 81. Accordingly, as shown in Fig. 6, the peripheral region 513 of the film 51 where the light that has passed through the first region 71 reaches and the region 515 of the film 51 where the light that has passed through the opening formed region 724 reaches are photodecomposed across the entire thickness. On the other hand, as shown in Fig. 7, the region of the second region 72 except the dot regions 721 and the opening formed regions 724 has the semitransmissive portion 86. Accordingly, of the light directed to the process region 511 of the film 51 from the light source, only part of light directed to the regions to be the recesses 214 in the ground layer 21 reaches the surface of the film 51. Accordingly, as shown in Fig. 6, only part of the thickness of the film 51 is photodecomposed in the regions to be the recesses 214 in the ground layer 21.

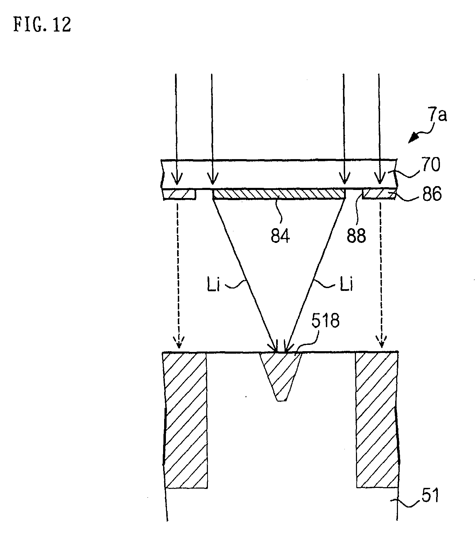

As shown in Fig. 7, each dot region 721 of the second region 72 is covered with the light-shielding portion 84. The regions of the process region 511 which are prevented from irradiation of light by the dot regions 721 are not removed by development to become the projections 213 of the ground layer 21. Fig. 11 is an enlarged plan view of the dot region 721. As shown in the drawing, the dot region 721 of this embodiment is substantially polygonal (hexagonal in this embodiment), so that the light-shielding portion 84 is also substantially polygonal. When the diameter d of the circumscribed circle C of the dot region 721 shown in Fig. 11 is too small, it is sometimes difficult to control a practically exposed region accurately during exposure process. Conversely, when the diameter d of the circumscribed circle C of the dot region 721 is too large, the top of the projection 213 of the ground layer 21 becomes flat to decrease the light-scattering effect by the reflecting layer 22 formed on the surface thereof. It is therefore desirable to set the diameter d of the circumscribed circle C of the dot region 721 to at least 8.0 µm and at most 11.0 µm and, more desirably, at least 9.0 µm and at most 10.0 µm.

It is preferable to determine the ratio of the total area of the multiple dot regions 721 to the area of the entire surface of the photomask 7a (the total area of the first region 71 and the second region 72) as follows: The dot regions 721 of this embodiment correspond to the regions of the film 51 which are to be the projections 213 on the ground layer 21. Accordingly, when the ratio of the area of the dot regions 721 to the entire surface of the photomask 7a is too small, the area of the projections 213 to the surface of the ground layer 21 also becomes small to increase a flat portion, thereby decreasing the light-scattering effect by the reflecting layer 22. Conversely, when the ratio of the area of the dot regions 721 to the entire surface of the photomask 7a is too large, the area of the projections 213 to the surface of the ground layer 21 also becomes large to increase a flat portion, thereby decreasing the light-scattering effect by the reflecting layer 22. Accordingly, in order to gain favorable light scattering effect by the reflecting layer 22, it is preferable to set the ratio of the total area of the dot regions 721 to the entire surface of the photomask 7a to at least 30 percent and at most 60 percent.

As shown in Fig. 11, a peripheral transmissive portion 88 is disposed around each dot region 721 such that it is in contact with the entire edge of the dot region 721 (the entire edge of the light-shielding portion 84). The peripheral transmissive portion 88 has neither of the light-shielding portion 84 and the semitransmissive portion 86 (or the substrate 70 is exposed), as with the transmissive portion 81. The light emitted from the light source passes through the peripheral transmissive portion 88 at substantially the same light transmittance (approximately 100 percent) as that of the transmissive portion 81 and reaches the film 51. Fig. 12 is a cross-sectional view showing the path of transmitted light in the vicinity of the dot region 721. As shown in the drawing, the light that has passed through the peripheral transmissive portion 88 around the dot region 721 is diffracted around the edge of the light-shielding portion 84 that covers the dot region 721 and then reaches the surface of the film 51. Since the optical path lengths of the diffracted light Li that has passed through the peripheral transmissive portion 88 onto the surface of the film 51 are equal, the phase difference of the diffracted light Li at the surface of the film 51 becomes zero, so that the diffracted light Li is mutually intensified on the surface of the film 51. Thus a region 518 of the film 51 which corresponds to the top of the projection 213 is partly photodecomposed and then developed to form the recess 213a at the top of the projection 213, as shown in Figs. 3 and 4.

As has been described, since the photomask 7a according to the embodiment has the semitransmissive portion 86 which overlaps with the portion of the process region 511 which is to be the recess 214 in the ground layer 21, only part of the thickness of the region is photodecomposed. Accordingly, the surface of the second substrate 20 is not exposed at the bottom of the recess 214 of the ground layer 21, so that the reflecting layer 22 disposed on the surface of the ground layer 21 offers a preferable light-scattering effect. The photomask 7a allows the exposure for removing the periphery of the process region 511 and the partial exposure of portions corresponding to the recesses 214 of the ground layer 21 to be performed by the common process step, thus simplifying the manufacturing process and reducing manufacturing cost as compared with the conventional arts.

### <B: Second Embodiment>

The first embodiment has been described for the structure in which the projections 213 of the ground layer 21 are formed to correspond to the dot regions 721 of the photomask 7a by way of example. In contrast, a second embodiment is constructed such that the recesses 214 of the ground layer 21 correspond to the dot regions 721 of a photomask 7b. The photomask 7b according to this embodiment is used to expose the positive film 51 to light, as with the first embodiment. Description of items of the embodiment in common with the first embodiment will be omitted as appropriate.

Fig. 13 is a plan view showing the structure of the photomask 7b according to the second embodiment. As shown in the drawing, although the photomask 7b is the same as the photomask 7a according to the first embodiment in that the first region 71 and the opening formed regions 724 serve as the transmissive portion 81, the positional relationship between the light-shielding portion 84 and the semitransmissive portion 86 is opposite to that of the photomask 7a. Specifically, the portions of the second region 72 of the photomask 7b which correspond to the multiple dot regions 721 have the semitransmissive portions 86, and a region other than the dot regions 721 has the light-shielding portion 84. The edge of each dot region 721 (the edge of each semitransmissive portion 86) of the photomask 7b has the peripheral transmissive portion 88, as with the first embodiment.

A method for manufacturing the liquid crystal display 100 according to the embodiment is the same as the manufacturing method for the first embodiment except that the photomask 7b is used in the exposure process of Fig. 5(b). In the exposure process of Fig. 5(b), the peripheral region 513 of the film 51 and the region 515 are photodecomposed across the entire thickness by the light that has passed through the first region 71 of the photomask 7b, as with the first embodiment. The portions of the process region 511 of the film 51 which are to be the recesses 214 of the ground layer 21 are irradiated with light that has passed through the semitransmissive portions 86 formed on the dot regions 721 of the photomask 7b and are photodecomposed across the part of the thickness. On the other hand, light that travels to the region overlapping with a region other than the dot regions 721 of the process region 511 is shielded by the light-shielding portion 84 and so, is not removed by development. Accordingly, the surface of the ground layer 21 which is obtained through the exposure process using the photomask 7b becomes a roughened surface in which the multiple recesses 214 are dispersed at random. Also the second embodiment offers the same advantages as those of the first embodiment.

### <Third Embodiment>

The first and second embodiments have been described for the case in which the ground layer 21 is formed by processing the film 51 made of a positive photosensitive material. In contrast, the film 51 according to the third embodiment is made of a negative photosensitive material. Description of items of the embodiment in common with the first embodiment will be omitted as appropriate.

Fig. 14 is a plan view showing the structure of a photomask 7c according to the third embodiment. With the photomask 7c according to this embodiment, in order to expose the film 51 made of a negative photosensitive material, the positional relationship between the light-shielding portion 84 and the transmissive portion 81 is opposite to that of the photomask 7a of the first embodiment (refer to Fig. 7), as shown in Fig. 14. Specifically, the first region 71 and the opening formed regions 724 of the photomask 7c have the light-shielding portion 84 and the dot regions 721 of the second region 72 have the transmissive portion 81. The photomask 7c is the same as the photomask 7a according to the first embodiment in that the region other than the dot regions 721 of the second region 72 has the semitransmissive portion 86.

A method for manufacturing the liquid crystal display 100 according to the third embodiment is the same as the manufacturing method for the first embodiment except that the film 51 is made of a negative photosensitive material in the process of Fig. 5(a) and the photomask 7c is used in the exposure process of Fig. 5(b). In the exposure process of Fig. 5(b), light that travels toward the peripheral region 513 of the film 51 and the region 515 is shielded by the light-shielding portions 84 and as such, those regions are removed by development. The regions of the film 51 which are irradiated with the light that has passed through the dot regions 721 of the photomask 7c are exposed to light across the entire thickness to become insoluble to a developer. Thus the portions of the process region 511 of the film 51 which overlap with the dot regions 721 form the projections 213 on the surface of the ground layer 21. Light that has passed through the semitransmissive portion 86 in the region other than the dot regions 721 of the second region 72 of the photomask 7c reaches the film 51 to expose only part of the thickness thereof. Thus only part of the thickness of the region is removed by development to form the recesses 214 in the ground layer 21. Also the embodiment offers the same advantages as those of the first embodiment.

### <D: Fourth Embodiment>

The third embodiment has been described for the structure in which the projections 213 of the ground layer 21 correspond to the dot regions 721 of the photomask 7c by way of example. In contrast, a fourth embodiment is constructed such that the recesses 214 in the ground layer 21 correspond to the dot regions 721 of a photomask 7d. The ground layer 21 according to the fourth embodiment is made of a negative photosensitive material, as with the third embodiment. The embodiment is the same as the second embodiment except the kind of the photosensitive material of the film 51 and the resulting structure of the photomask 7d.

Fig. 15 is a plan view showing the structure of the photomask 7d according to the fourth embodiment. As shown in the drawing, the positional relationship between the light-shielding portion 84 and the transmissive portion 81 is opposite to that of the photomask 7b of the second embodiment. Specifically, the first region 71 and the opening formed regions 724 of the photomask 7d have the light-shielding portion 84, while the region other than the dot regions 721 of the second region 72 has the transmissive portion 81. The photomask 7d is the same as the photomask 7b according to the second embodiment in that the dot regions 721 of the second region 72 have the semitransmissive portion 86.

A method for manufacturing the liquid crystal display 100 according to the embodiment is the same as the manufacturing method for the first embodiment except that the film 51 is made of a negative photosensitive material in the process of Fig. 5(a) and the photomask 7d is used in the exposure process of Fig. 5(b). In the exposure process of Fig. 5(b), light that travels toward the peripheral region 513 of the film 51 and the region 515 is shielded by the light-shielding portions 84 and as such, those regions are removed by development. The regions of the film 51 which are irradiated with the light that has passed through the region other than the dot regions 721 of the photomask 7d are exposed to light across the entire thickness to become insoluble to a developer. Light that has passed through the semitransmissive portion 86 in the dot regions 721 of the second region 72 of the photomask 7d reaches the film 51 to expose only part of the thickness thereof. Thus only part of the thickness of the region is removed by development to form the recesses 214 in the ground layer 21. Also the embodiment offers the same advantages as those of the first embodiment.

### <E: Fifth Embodiment>

This embodiment is another structural example of the scattering structure (a roughened surface including a large number of fine projections or recesses) formed on the surface of the reflecting layer 22 according to the first embodiment (refer to Fig. 1). The embodiment is the same as that of the first embodiment except the structure of the photomask and the scattering structure formed by using the photomask, and the description of common items with the first embodiment will be omitted as appropriate.

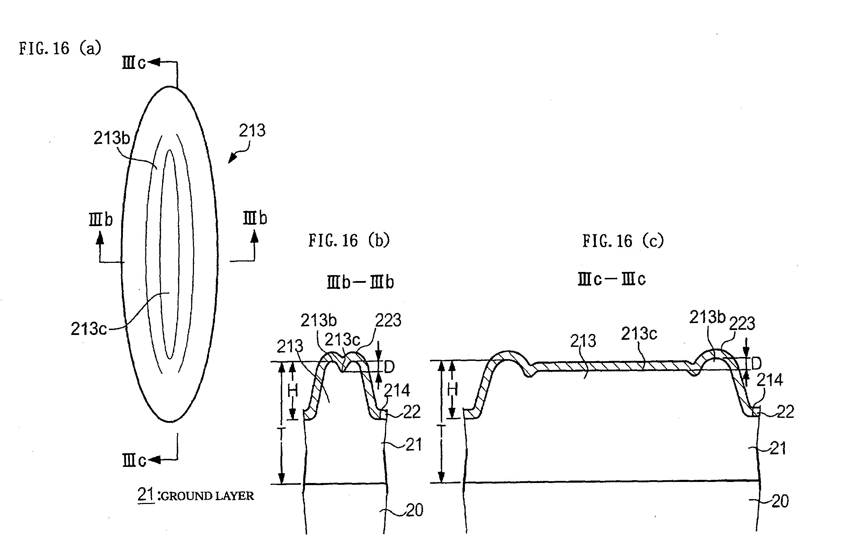

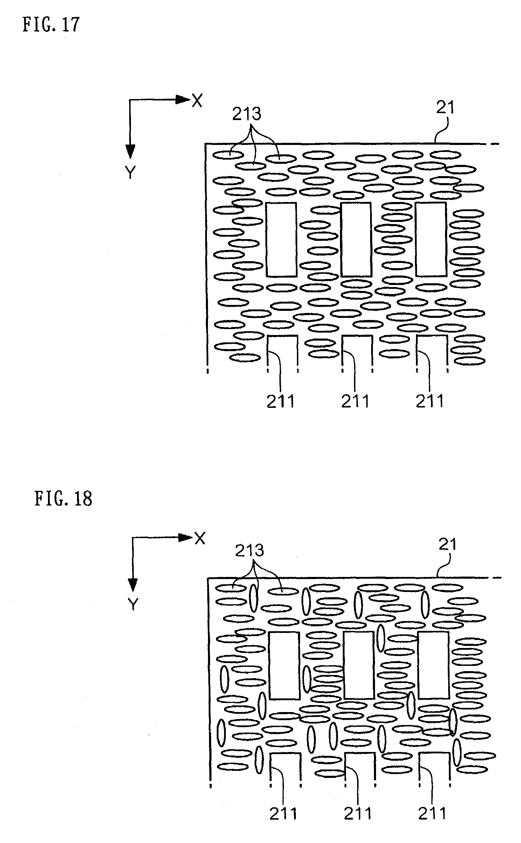

Figs. 16A is an enlarged plan view of one projection 213 of the roughened surface of the ground layer 21 formed on the surface of the second substrate 20 of the liquid crystal display 100. Fig. 17 is a plan view of the surface of the ground layer 21, showing the arrangement of the projections 213 as viewed from a direction perpendicular to the surface of the second substrate 20. As shown in the drawings, the projection 213 is substantially oblate (substantially elliptical in this embodiment) in plan view. As shown in Fig. 17, the projections 213 are scattered at random over the entire surface of the ground layer 21. The projections 213 are arranged on the surface of the ground layer 21 such that the long sides of the ellipses (the long axes of the ellipses) of the projection 213 in plan view point substantially in the same X-direction, or vertically on the display surface.

Fig. 16B is a cross-sectional view taken along line IIIb-IIIb of Fig. 16A. Fig. 16C is a cross-sectional view taken along line IIIc-IIIc of Fig. 16A. Figs. 16B and 16C illustrate the reflecting layer 22 in addition to the ground layer 21. As shown in the drawings, let the distance from the top 213b of each projection 213 which projects toward the first substrate 10 most to the region other than the projection 213 of the ground layer 21 (hereinafter, referred to as a recess) 214 be the height H of the projection 213. The height H of the projection 213 is smaller than the thickness T of the ground layer 21 (the distance between the contact surface with the second substrate 20 and the top 213b of the projection 213). In other words, the depth of the recess 214 (or the height H of the projection 213) on the surface of the ground layer 21 is selected so that the second substrate 20 is not exposed at the bottom of the recess 214.

As shown in Figs. 16B and 16C, a recess 213c is provided at the top 213b of each projection 213. The recess 213c is formed longitudinally along the long side of the projection 213. The depth D of the recess 213c is smaller than the height H of the projection 213. Since the surface of the ground layer 21 according to the fifth embodiment is roughened as described above, also the surface of the reflecting layer 22 formed on the ground layer 21 has also multiple fine projections 223 each having a recess on the top, as shown in Figs. 16B and 16C. If the top of each projection 223 which constructs the scattering structure of the reflecting layer 22 is flat, the incident light from the observer side is mirror-reflected by the flat surface, so that sufficient light-scattering effect to prevent the reflection of background cannot always be offered. In contrast, the scattering structure according to this embodiment allows reflected light by the reflecting layer 22 to be scattered also at the tops of the projections 223, having a preferable light-scattering effect of preventing the reflection of background completely.

The light that has reached the surface of the reflecting layer 22 is scattered mainly at the slopes (sides) of the projections 223 formed on the surface of the reflecting layer 22. Since the long sides of the projections 213 of the ground layer 21 according to the embodiment are pointed in the X-direction, the number of the projections 213 arranged in the X-direction is larger than that of the projections 213 arranged in the Y-direction as shown Fig. 17. Accordingly, the number of the slopes in the Y-direction is larger than that of the slopes in the X-direction when the projections 223 on the surface of the reflecting layer 22 are viewed from the X-direction and the Y-direction, respectively. Thus, according to the embodiment, the amount of light that scatters in the Y-direction on the surface of the reflecting layer 22 is larger than that of light that scatters in the X-direction. Since the X-direction agrees with the vertical length of the display surface here, this embodiment can achieve light display across the wide viewing angle along the lateral length (the Y-direction) of the display surface. On the other hand, setting the X-direction as the lateral length of the display surface achieves light display across the wide viewing angle along the vertical length of the display surface. As has been described, it is preferable to select the orientation of the long sides of the projections 213 of the ground layer 21 appropriately according to the direction in which a wide viewing angle is required for the liquid crystal display 100. Although a structure in which the long sides of all the projections 213 are pointed in one direction (X-direction) has been shown by way of example, the invention may have a structure in which the projections 213 of which the long sides are pointed in the X-direction and the projections 213 of which the long sides are pointed in the Y-direction are mixed on the surface of the ground layer 21, as shown in Fig. 18. Such a structure allows the vertical and lateral viewing-angle characteristics on the display surface to be adjusted appropriately according to the ratio of the number of the X-directional projections 213 to the number of the Y-directional projections 213.

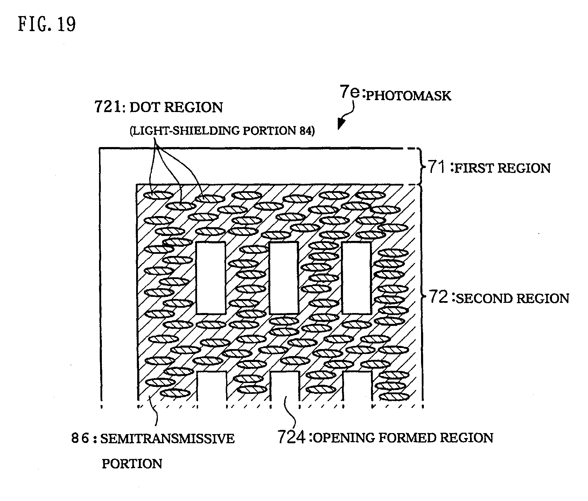

The structure of a photomask 7e used in the exposure process (refer to Fig. 5(b)) will now be described. Fig. 19 is a plan view showing the structure of the photomask 7e. As shown in the drawing, the photomask 7e according to the embodiment is segmented into the first region 71 and the second region 72 in plan view. The first region 71 is opposed to the peripheral region 513 of the film 51 during the exposure process (refer to Fig. 5(b)). The second region 72 is opposed to the process region 511 of the film 51 during the exposure process. The second region 72 includes the large number of dot regions 721 which are dispersed at random and the regions (opening formed regions) 724 corresponding to the openings 211 in the ground layer 21. The dot regions 721 correspond to the projections 213 on the surface of the ground layer 21.

Referring to Fig. 19, the densely hatched region has the light-shielding portion 84, the non-densely hatched region has the semitransmissive portion 86, and the no-hatched region has neither of the light-shielding portion 84 and the semitransmissive portion 86. As shown in the drawing, the first region 71 of the photomask 7e has neither of the light-shielding portion 84 and the semitransmissive portion 86. In other words, the first region 71 of the photomask 7e has only the substrate 70 and thus serves as a transmissive region that transmits light that is directed to the peripheral region 513 from the light source. Also the opening formed region 724 has only the substrate 70, as with the first region 71, and serves as a transmissive region. Accordingly, the peripheral region 513 of the film 51 where the light that has passed through the first region 71 reaches and the region 515 of the film 51 where the light that has passed through the opening formed region 724 reaches are photodecomposed across the entire thickness (refer to Fig. 6).

On the other hand, as shown in Fig. 19, the region of the second region 72 except the dot regions 721 and the opening formed regions 724 has the semitransmissive portion 86. Thus the region serves as a semitransmissive portion that transmits light that travels toward the process region 511 at a light transmittance lower than that of the first region 71. Accordingly, of the light that travels from the light source toward the process region 511 of the film 51, only part of light directed to the regions of the ground layer 21 which are to be the recesses 214 reaches the surface of the film 51. Accordingly, only part of the thickness of the film 51 is photodecomposed in the regions to be the recesses 214 in the ground layer 21.

As shown in Fig. 19, the dot regions 721 of the second region 72 are covered with the light-shielding portion 84 and so serve as a light-shielding region for shielding the light that travels from the light source toward the film 51. The regions of the process region 511 which are prevented from irradiation of light by the dot regions 721 are not removed by development to form the projections 213 on the ground layer 21. It is preferable to determine the ratio of the total area of the multiple dot regions 721 to the area of the entire surface of the photomask 7e (the total area of the first region 71 and the second region 72) as follows, as in the first embodiment: The dot regions 721 correspond to the regions of the film 51 which are to be the projections 213 on the ground layer 21. Accordingly, when the ratio of the area of the dot regions 721 to the entire surface of the photomask 7e is too small, the ratio of the area of the projections 213 to the surface of the ground layer 21 also becomes small to increase a flat portion, thereby decreasing the light-scattering effect by the reflecting layer 22. On the other hand, when the ratio of the area of the dot regions 721 to the entire surface of the photomask 7e is too large, the ratio of the area of the projections 213 to the surface of the ground layer 21 also becomes large to increase a flat portion, thereby decreasing the light-scattering effect by the reflecting layer 22. Accordingly, in order to obtain a preferable light-scattering effect by the reflecting layer 22, it is preferable to set the ratio of the total area of the dot regions 721 to the entire surface of the photomask 7a to at least 30 percent and at most 60 percent.

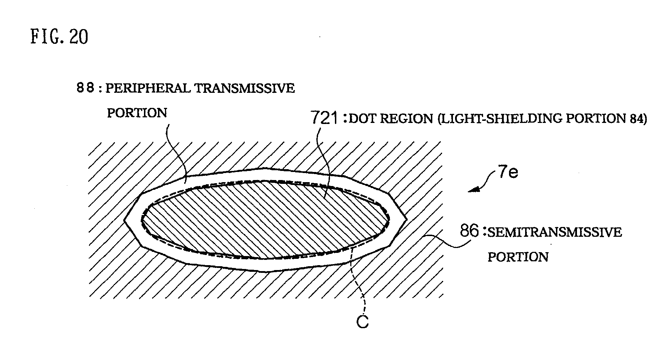

Fig. 20 is an enlarged plan view of the dot region 721. As shown in the drawing, the dot region 721 of this embodiment is substantially polygonal (dodecagonal in this embodiment), so that the light-shielding portion 84 is also substantially polygonal. More specifically, as shown in Fig. 20, the planar shape of the dot region 721 (the light-shielding portion 84 of the dot region 721) is selected so that the circumscribed circle C thereof becomes substantially an oblate ellipsoid (not a perfect circle but an oblong circle). This embodiment is assumed that the circumscribed circle C is elliptical.

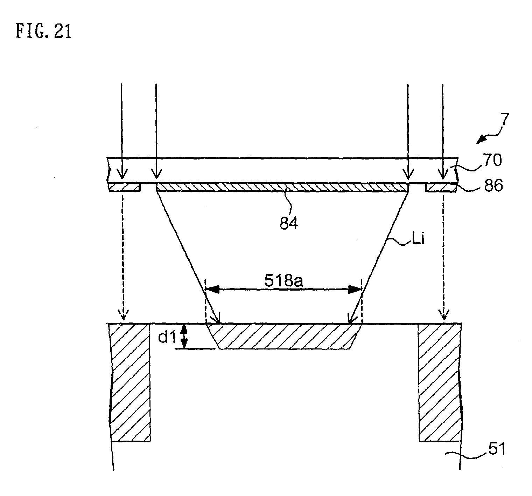

As shown in Fig. 20, the peripheral transmissive portion 88 is provided along the edge of each dot region 721 (the edge of the light-shielding portion 84). The peripheral transmissive portion 88 according to the embodiment is in contact with the entire edge of the dot region 721 and has neither of the light-shielding portion 84 and the semitransmissive portion 86, as with the first region 71. The light emitted from the light source therefore passes through the peripheral transmissive portion 88 at substantially the same light transmittance as that of the first region 71 (about 100 percent which is the transmittance of the substrate 70) and reaches the film 51. Fig. 21 is a cross-sectional view showing the path of transmitted light in the vicinity of the dot region 721.

As shown in Fig. 21, the light that has passed through the peripheral transmissive portion 88 around the dot region 721 is diffracted around the edge of the light-shielding portion 84 that covers the dot region 721 and then reaches the surface of the film 51. Since the diffracted light Li reaches the region of the film 51 which faces the dot region 721 and is intensified at the portion opposed to the focus of each elliptical dot region 721. A region 518a is a region photodecomposed by the diffracted light Li around the edge of the dot region 721 of the film 51. The oblong region 518a along the length of the dot region 721 is photodecomposed across the depth d1 in the region opposed to the dot region 721 of the film 51 by application of the diffracted light Li along the edge of the dot region 721. The region 518a is removed across part of the thickness of the film 51 through the development process to form the recess 213c at the top 213b of the projection 213, as shown in Figs. 16A to 16C.

The invention may adopt a structure (comparative example) in which the planer shape of the dot region 721 is a perfect circle or a polygon of which the circumscribed circle is a perfect circle, which can pose the problem that the recess 213c becomes too deep. When the planar shape of the dot region 721 is a perfect circle, the diffracted light Li around the entire edge of the dot region 721 concentrates into the region 518a of the film 51 substantially at the same phase, as with the substantially polygon of the first embodiment (refer to Fig. 11) to be intensified mutually (refer to Fig. 12). Since the diffracted light Li concentrates in the small area in that way, the depth of the portion of the film 51 which is photodecomposed by the diffracted light Li becomes larger than the maximum depth d1 of the region 518a which is photodecomposed by the diffracted light Li around the dot region 721 of this embodiment. The surface of the ground layer 21 formed by developing the film 51 which has passed through the exposure process has a very deep recess 213c at the top 213b of the projection 213. Test results by the inventor have shown that when the recess 213c at the top of 213b the projection 213 of the ground layer 21 is too deep, the light-scattering characteristic of the reflecting layer 22 formed on the roughened surface is not necessarily high. By contrast, according to this embodiment, since the diffracted light Li around the dot regions 721 reaches the film 51 dispersedly across a wide region, the depth d1 of the photodecomposed region of the film 51 is reduced. Thus, the use of the photomask 7e offers the reflecting layer 22 having a preferable light-scattering effect.

As has been described, the photomask 7e according to the embodiment offers the same advantages as those of the first embodiment.

### <F: Modifications>

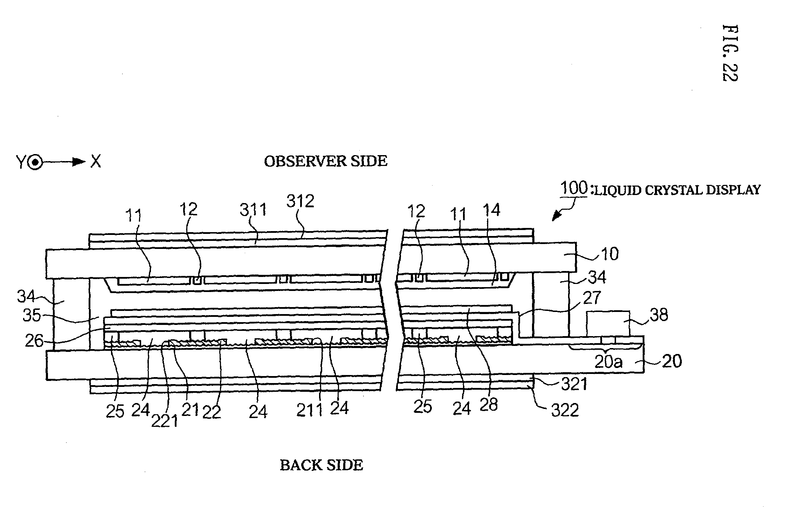

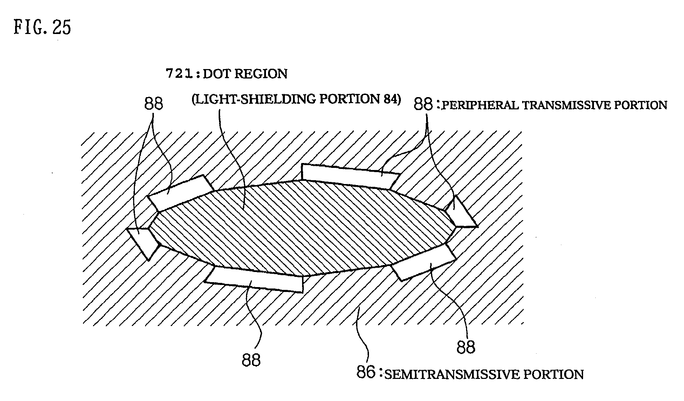

The above-described embodiments are mere examples. It is to be understood that various modifications can be made without departing from the spirit and scope of the invention. Specifically, the following modifications can be made.
(1) Although the foregoing embodiments have a structure in which the ground layer 21 has the openings 211 corresponding to the pixels, the ground layer 21 can have no openings 211, as shown in Fig. 22. With the structure of Fig. 22, however, part of light that travels from the second substrate 20 toward the first substrate 10 is absorbed by the ground layer 21 in transmissive display. It is therefore desirable to provide the openings 211 in the ground layer 21, as in the foregoing embodiments, in terms of reducing loss in light amount for transmissive display. Although the foregoing embodiments have been described for the so-called semitransflective liquid crystal display 100 capable of reflective display and transmissive display by way of example, the invention can be applied also to the liquid crystal display 100 capable of only reflective display, in which case the openings 211 and the transmissive portion 221 of the reflecting layer 22 are not provided. Thus the photomasks 7 (7a, 7b, 7c, and 7d) have no opening formed region 724.
(2) Although the foregoing embodiments have the single-layer light-shielding portion 84, the invention may have the light-shielding portion 84 in which a light-shielding layer made of chromium etc. and a half-tone semitransmissive portion 86 are deposited. Such a structure increases the light-shielding characteristic of the light-shielding portion 84.
(3) Although the dot regions 721 of the photomasks 7a, 7b, 7c, and 7d according to the first to fourth embodiments are substantially polygonal, the dot regions 721 may have any planar shapes, such as polygons other than a regular polygon. When the planar shape of the dot region 721 is a polygon, each vertical angle thereof is desirably an obtuse angle. This is because when the vertical angles of the dot region 721 are obtuse, light may be diffracted in the vicinity thereof to prevent prescribed exposure.
(4) Although the first and second embodiments have been described for the structure in which the peripheral transmissive portion 88 is arranged in contact with the entire edge of the dot region 721, the invention may have a structure in which the peripheral transmissive portion 88 is partly in contact with the edge of the dot region 721 (the light-shielding portion 84 in this case), as shown in Fig. 23. Fig. 23 shows a structure in which the peripheral transmissive portion 88 is provided only along three sides of the substantially hexagonal dot region 721 which are not adjacent to each other.
   The structure of Fig. 11 (refer to the first embodiment) has the possibility that the recess 213a at the top of the projection 213 may become too deep because of a large amount of light that passes through the peripheral transmissive portion 88 along the entire edge of the dot region 721 to reach the region 518 of the film 51. In contrast, the structure according to the modification can reduce the amount of diffracted light that has passed through the peripheral transmissive portion 88 to reach the region 518 of the film 51, as compared with the case of Fig. 12, preventing the recess 213a from becoming too deep. As has been described, it is preferable to select the shape of the peripheral transmissive portion 88 so that the recess 213a has the optimum depth.
(5) Although the dot regions 721 of the photomask 7e according to the fifth embodiment is substantially polygonal having an elliptical circumscribed circle, the dot regions 721 may have any planar shapes. For example, as shown in Fig. 24, the dot region 721 may have a substantially polygonal planar shape or, alternatively, a planer shape having a rectangle (or square) S to the opposite sides of which a semicircle R with the diameter thereof is added. The "oblate figure" of the invention includes not only a perfect ellipse but also all oblong circles (circles other than a perfect circle).
(6) Although the fifth embodiment has been described for the structure in which the peripheral transmissive portion 88 is arranged in contact with the entire edge of the dot region 721 (refer to Fig. 20), the invention may have a structure in which the peripheral transmissive portion 88 is partly in contact with the edge of the dot region 721 (the edge of the light-shielding portion 84), as shown in Fig. 25. Fig. 25 shows a structure in which the peripheral transmissive portion 88 is provided only along four sides of the substantially octagonal dot region 721 which are not adjacent to each other.
   The structure of Fig. 20 has the possibility that the recess 213b (refer to Figs. 16A to 16C) at the top of the projection 213 may become too deep depending on the amount of light from the light source because the light from the light source is diffracted across the entire edge of the dot region 721 to reach the region 518a (refer to Fig. 21) of the film 51. In contrast, the structure according to the modification can reduce the amount of diffracted light that has passed through the peripheral transmissive portion 88 to reach the region 518 of the film 51 as compared with the case of Fig. 20, thus preventing the recess 213b from becoming too deep. As has been described, it is preferable to select the shape of the peripheral transmissive portion 88 so that the recess 213b has the optimum depth. With a structure having no peripheral transmissive portion 88, the light that has passed through the semitransmissive portion 86 around the edge of the dot region 721 is diffracted at the edge of the dot region 721, thus having the similar advantages to those of the foregoing embodiments.
(7) Although the foregoing embodiments have been described for a liquid crystal display by way of example, the invention can also be applied to other electrooptic devices. Specifically speaking, the invention can be applied to devices that display images using electrooptic materials for converting an electric action of supplying image signals to an optical action such as change in brightness or light transmittance. For example, the invention can be applied to various electrooptic devices such as an electrophoretic display device which uses a microcapsule containing colored liquid and white particles dispersed in the liquid as an electrooptic material, a twist-ball display using twist balls which are colored in different colors for regions of different phases as an electrooptic material, and a toner display using a black toner as an electrooptic material.

The substrate for electrooptic devices according to the invention is particularly preferable for electrooptic materials that display images using electrooptic materials that emit no light by itself. However, the invention can also be applied to electrooptic devices using electrooptic materials that emit light by itself (self-luminous electrooptic materials). For example, disposing the substrate for electrooptic devices according to the invention on the back of the self-luminous electrooptic material achieves light display by reflecting light emitted from the electrooptic material to the observer side. Electrooptic devices that use the self-luminous electrooptic materials include display devices that use organic light-emitting diode (OLED) elements such as organic ELs or light-emitting polymers as electrooptic materials, plasma display panels (PDPs) that use high-pressure gas such as helium or neon as electrooptic materials, and field emission displays (FEDs) that use fluorescent materials as electrooptic materials.

### <G: Electronic Device>

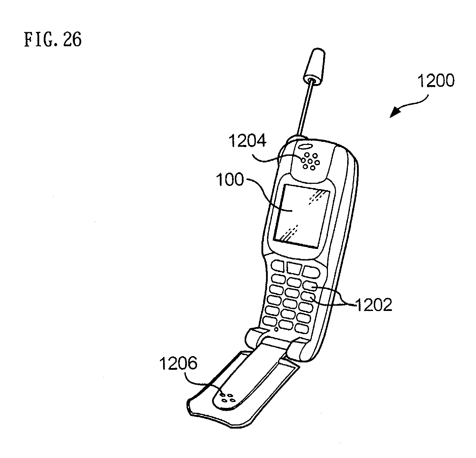

An electronic device having the electrooptic device according to the invention as display device will then be described. Fig. 26 is a perspective view showing the structure of a cellular phone using the liquid crystal display 100 according to the foregoing embodiments. As shown in the drawing, a cellular phone 1200 includes multiple operation buttons 1202, an earpiece 1204, a mouthpiece 1206, and the liquid crystal display 100.

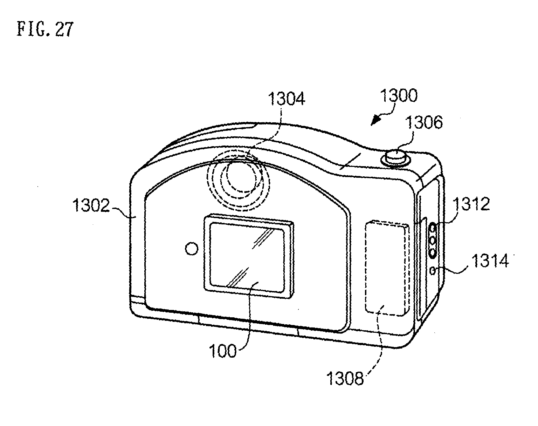

Fig. 27 is a perspective view showing the structure of a digital still camera incorporating the liquid crystal display 100 according to the embodiments as a finder. A digital still camera 1300 has the liquid crystal display 100 according to the embodiments on the back of a body 1302. Since the liquid crystal display 100 displays images according to an imaging signal, it serves as a finder for displaying an object. The body 1302 has a photoreceptor unit 1304 including an optical lens and a CCD on the front (on the back in Fig. 27). When a photographer recognizes an object image displayed on the liquid crystal display 100 and pushes a shutter button 1306, the imaging signal of the CCD at that point in time is transferred and stored into the memory of a circuit board 1308. The digital still camera 1300 has a video-signal output terminal 1312 for external display and a data-communication input/output terminal 1314 on the side of a case 1302.

The electronic devices which use the electrooptic devices according to the invention as display device include notebook personal computers, liquid crystal televisions, viewfinder (direct-viewing monitor) video recorders, vehicle navigation systems, pagers, electronic databooks, electric calculators, word processors, work stations, picture telephones, POS terminals, and devices including a touch panel, in addition to the cellular phone of Fig. 26 and the digital still camera of Fig. 27.

## Claims

1. A photomask used for an exposure process for roughening the surface of a process region of a film, the photomask comprising:
a first region including a transmissive portion that transmits light traveling toward the periphery of the process region; and
a second region including a plurality of dot regions each having a light-shielding portion that shields light traveling toward the process region and a semitransmissive portion that transmits the light traveling toward the process region in a region other than the dot regions, the semitransmissive portion transmitting the light at a lower transmittance than that of the transmissive portion.

2. A photomask used for an exposure process for roughening the surface of a process region of a film, the photomask comprising:
a first region including a transmissive portion that transmits light traveling toward the periphery of the process region; and
a second region including a plurality of dot regions each having a semitransmissive portion that transmits light traveling toward the process region at a lower transmittance than that of the transmissive portion and a light-shielding portion that shields the light traveling toward the process region in a region other than the dot regions.

3. A photomask used for an exposure process for roughening the surface of a process region of a film, the photomask comprising:
a first region including a transmissive portion that transmits light traveling toward the periphery of the process region;
a second region including a plurality of dot regions each having a light-shielding portion that shields light traveling toward the process region and a semitransmissive portion that transmits the light traveling toward the process region in a region other than the dot regions, the semitransmissive portion transmitting the light at a lower transmittance than that of the transmissive portion; and
a peripheral transmissive portion disposed in a region in contact with the entire edge of each dot region, for transmitting light at substantially the same light transmittance as that of the transmissive portion.

4. A photomask used for an exposure process for roughening the surface of a process region of a film, the photomask comprising:
a first region including a transmissive portion that transmits light traveling toward the periphery of the process region;
a second region including a plurality of dot regions each having a semitransmissive portion that transmits light traveling toward the process region at a lower transmittance than that of the transmissive portion and a light-shielding portion that shields the light traveling toward the process region in a region other than the dot regions; and
a peripheral transmissive portion disposed in a region in contact with the entire edge of each dot region, for transmitting light at substantially the same light transmittance as that of the transmissive portion.

5. A photomask used for an exposure process for roughening the surface of a process region of a film, the photomask comprising:
a first region including a transmissive portion that transmits light traveling toward the periphery of the process region;
a second region including a plurality of dot regions each having a light-shielding portion that shields light traveling toward the process region and a semitransmissive portion that transmits the light traveling toward the process region in a region other than the dot regions, the semitransmissive portion transmitting the light at a lower transmittance than that of the transmissive portion; and
a peripheral transmissive portion disposed in a region in contact with part of the edge of each dot region, for transmitting light at substantially the same light transmittance as that of the transmissive portion.

6. A photomask used for an exposure process for roughening the surface of a process region of a film, the photomask comprising:
a first region including a transmissive portion that transmits light traveling toward the periphery of the process region;
a second region including a plurality of dot regions each having a semitransmissive portion that transmits light traveling toward the process region at a lower transmittance than that of the transmissive portion and a light-shielding portion that shields the light traveling toward the process region in a region other than the dot regions; and
a peripheral transmissive portion disposed in a region in contact with part of the edge of each dot region, for transmitting light at substantially the same light transmittance as that of the transmissive portion.

7. A photomask used for an exposure process for roughening the surface of a process region of a film, the photomask comprising:
a first region including a light-shielding portion that shields light traveling toward the periphery of the process region; and
a second region including a plurality of dot regions each having a transmissive portion that transmits light traveling toward the process region and a semitransmissive portion that transmits the light traveling toward the process region in a region other than the dot regions, the semitransmissive portion transmitting the light at a lower transmittance than that of the transmissive portion.

8. A photomask used for an exposure process for roughening the surface of a process region of a film, the photomask comprising:
a first region including a light-shielding portion that shields light traveling toward the periphery of the process region; and
a second region including a plurality of dot regions each having a semitransmissive portion that transmits light traveling toward the process region and a transmissive portion that transmits the light traveling toward the process region in a region other than the dot regions, the light transmittance of the semitransmissive portion is lower than that of the transmissive portion.

9. The photomask according to claim 1, the light transmittance of the semitransmissive portion being at least 10 percent and at most 40 percent.

10. The photomask according to claim 1, the semitransmissive portion having a plurality of fine light-shielding portions for shielding light and a plurality of fine transmissive portions for transmitting light.

11. The photomask according to claim 10, the semitransmissive portion having the fine light-shielding portions and the fine transmissive portions disposed alternately in a first direction and a second direction different from the first direction.

12. The photomask according to claim 11, each of the fine light-shielding portions and the fine transmissive portions being a rectangle 2 µm or less on a side.

13. The photomask according to claim 10, the semitransmissive portion having the fine light-shielding portions and the fine transmissive portions extending in a first direction disposed alternately in a second direction orthogonal to the first direction.

14. The photomask according to claim 13, each of the fine light-shielding portions and the fine transmissive portions being 2 µm or less in width.

15. The photomask according to claim 1, the dot region being polygonal in planar shape, the circumscribed circle of which being at least 8 µm and at most 11 µm in diameter.

16. The photomask according to claim 1, the dot region having a substantially oblate planar shape or a substantially polygonal planar shape whose circumscribed circle is oblate.

17. The photomask according to claim 16, the dot regions being arranged longitudinally in the same direction.

18. The photomask according to claim 1, the ratio of the area of the dot regions to the total area of the first region and the second region being at least 30 percent and at most 60 percent.

19. A method for manufacturing an electrooptic device substrate including a ground layer having a roughened surface and a reflecting layer disposed on the roughened surface of the ground layer, the method comprising;
a film forming process of forming a film of a positive photosensitive material;
an exposure process of exposing the film to light through a photomask, the process comprising the step of shielding light from a light source traveling toward one of regions to be the projections of the roughened surface and regions to be the recesses with a light-shielding portion of the photomask and the step of passing light from the light source traveling toward the other of the regions through a semitransmissive portion of the photomask, thereby applying the light only to part of the thickness of the film;
a developing process of developing the exposed film to form the ground layer; and
a reflecting-layer forming process of forming the reflecting layer having light reflexibility on the roughened surface of the ground layer formed by the developing process.

20. The method for manufacturing an electrooptic device substrate according to claim 19, in the exposure process, the light traveling toward the regions to be the projections of the roughened surface being shielded by the light-shielding portion, the light traveling toward the regions to be the recesses of the roughened surface being passed through the semitransmissive portion, and light that has passed through a peripheral transmissive portion provided around the light-shielding portion of the photomask being diffracted around the edge of the light-shielding portion to be applied to the regions to be the tops of the projections.

21. A method for manufacturing an electrooptic device substrate including a ground layer having a roughened surface and a reflecting layer disposed on the roughened surface of the ground layer, the method comprising;
a film forming process of forming a film of a negative photosensitive material;
an exposure process of exposing the film to light through a photomask, the process comprising the step of passing light from a light source traveling toward one of regions to be the projections of the roughened surface and regions to be the recesses through a transmissive portion of the photomask, thereby applying the light to the entire thickness of the film, and the step of passing light from the light source traveling toward the other of the regions through a semitransmissive portion of the photomask, thereby applying the light only to part of the thickness of the film;
a developing process of developing the exposed film to form the ground layer;
and
a reflecting-layer forming process of forming the reflecting layer having light reflexibility on the roughened surface of the ground layer formed by the developing process.

22. A method for manufacturing an electrooptic device comprising an electrooptic device substrate including a ground layer having a roughened surface and a reflecting layer disposed on the roughened surface of the ground layer, the method comprising the steps of:
manufacturing the electrooptic device substrate by the method according to claim 19; and
disposing an electro-optic material so as to face the reflecting layer of the electrooptic device substrate.

23. An electrooptic device substrate comprising:
a ground layer having a plurality of projections on the surface, the projections each having a recess on the top thereof; and
a light-reflective reflecting layer disposed on the surface of the ground layer, the surface including the plurality of projections.

24. An electrooptic device substrate comprising:
a ground layer having a plurality of projections on the surface, the projections being substantially oblate in planar shape and each having a recess on the top thereof; and
a light-reflective reflecting layer disposed on the surface of the ground layer, the surface having the plurality of projections.

25. An electrooptic device comprising:
a first substrate and a second substrate opposed to each other and having an electro-optic material therebetween;
a ground layer disposed on the surface of the second substrate facing the electro-optic material and having a plurality of projections on the surface, the projections each having a recess on the top thereof; and
a light-reflective reflecting layer disposed on the surface of the ground layer, the surface having the plurality of projections.

26. An electronic device including the electrooptic device according to claim 25 as a display device.
